# EUROPEAN PATENT APPLICATION

(11) **EP 0 823 735 A1**
(43) Date of publication of application: **11.02.1998**
(21) Application number: 96410087.9
(22) Date of filing: 05.08.1996
(51) Int. Cl.: H01L 29/06, H01L 29/78, H01L 29/739

(54) **MOS-technology power device**

(71) Applicant: SGS-THOMSON MICROELECTRONICS S.A., 90 Rousset (FR)
(72) Inventor: Mille, Jacques, 13100 Aix-en-Provence (FR)
(74) Representative: Mittler, Enrico

(57) **Abstract**

MOS technology power device structure comprising a semiconductor substrate (1), a lightly doped semiconductor layer (2) of a first conductivity type superimposed over the substrate (1), a doped region (3) of a second conductivity type formed in the lightly doped layer, the doped region (3) comprising substantially parallel elongated body stripes (5) of the second conductivity type and a substantially annular frame (4) of the second conductivity type surrounding the body stripes (5) and merged with the body stripes (5) at ends thereof, source regions (9) of the first conductivity type formed inside the body stripes (5), substantially parallel elongated insulated gate stripes (6) extending over the lightly doped layer (2) between the body stripes (5). The insulated gate stripes (6) have a sinuous layout whereby the body stripes (5) comprise enlarged portions (7) longitudinally intercalated with narrow portions (8), the enlarged portions (7) of a body stripe being further intercalated in a direction transversal to the body stripes (5) with the narrow portions (8) of adjacent body stripes (5).

## Description

The present invention relates to a MOS-technology power device, particularly to a power VDMOSFET (Vertical Double-diffused MOSFET) or an IGBT (Insulated Gate Bipolar Transistor).

Conventionally, MOS-technology power devices comprise a heavily doped semiconductor substrate, over which a lightly doped semiconductor layer is formed, generally by means of epitaxial growth; the lightly doped layer is of the N conductivity type in the case of N-channel devices, and of the P conductivity type in the case of P-channel devices. Also, in the case of power VDMOSFETs the substrate is of the same conductivity type as the lightly doped layer, while in the case of IGBTs the substrate and the lightly doped layer are of opposite conductivity types. In the following of this description, it is discussed the case of an N-channel VDMOSFET; however, this description is still valid in the case of P-channel VDMOSFET (the conductivity type are to be interchanged) as well as in the case of N-channel or P-channel IGBTs.

The conventional structure of an N-channel VDMOSFET will be now described referring to some peculiar steps of its manufacturing process.

The substrate and the lightly doped layer form the drain of the VDMOSFET.

A thick oxide layer is grown over the top surface of the lightly doped layer and the oxide layer is selectively etched away from the region of the chip wherein the VDMOSFET is to be defined. A P+ deep body region can be formed at this step in the lightly doped layer by means of dopant implantation; however, in most recent device structures the P+ deep body region is not provided anymore.

Then, a gate oxide layer is formed over the surface of the lightly doped layer, and a polysilicon layer is deposited, doped and etched by means of a mask (usually called "poly mask") to open windows therein; the polysilicon layer, once etched, forms the gate electrode of the device and defines, by self-alignment, the shape of the active area of the device.

A P type region (usually called P body) is then formed by means of dopant implantation in the full area of the VDMOS using as an implantation mask the previously defined polysilicon layer; the P body is thus self-aligned with the windows in the polysilicon layer. The dopant is then made to diffuse, to form the bulk electrode of the device.

An N+ region is then formed in the full area of the VDMOS, again by means of dopant implantation using as an implantation mask the polysilicon layer; the implanted dopant is then made to diffuse slightly, the channel length of the device being determined by the difference in the lateral diffusion of the P body region with respect to the N+ region. The N+ region, forming the source electrode of the device, is also self-aligned with the windows in the polysilicon layer.

Since the bulk electrode and the source electrode of the VDMOS are to be short-circuited to each other by means of a common metallization layer, some part of the P body region is to be protected from the implantation of N type dopant forming the source electrode; this is conventionally obtained by providing a dedicated "source" mask which comprises some resist pads left inside the windows in the polysilicon layer over the P body region.

A dielectric layer is then deposited over the entire surface of the chip, and it is etched to open contact windows; inside each window in the polysilicon layer, the contact area extends over both the N+ and the P body regions (in structures wherein the P+ deep body region is provided, the contact area is superimposed over the P+ deep body region).

A metal layer is then deposited over the entire structure, as well as on the back side of the substrate.

In order to achieve a high current capability, several elementary VDMOSFET devices like that previously described are formed in the same chip, and are connected in parallel to each other; the substrate and the lightly doped layer form a common drain electrode of all the elementary VDMOSFET, the common gate electrode is represented by a mesh of polysilicon layer, and the common source electrode is a plate of metallization contacting the source and bulk electrodes of all the elementary VDMOSFET.

An electrical parameter typically used to identify the current capability of the power device is the on-state resistance (Ron) of the device for a given gate bias voltage.

The Ron depends on a lot of other parameters, some of which cannot be modified by design; for example, the thickness and doping level of the lightly doped layer strongly affect the Ron, but they are fixed by the desired breakdown voltage of the power device. Some other parameters, such as the channel resistance and the JFET resistance, depend however on the physical layout of the power device. The channel resistance is related (for a given manufacturing process) to the overall channel width per unit area; the channel width is directly related to the perimeter of the windows in the polysilicon layer. In order to reduce the channel resistance, the channel width, i.e. the perimeter of the windows in the polysilicon layer should be optimized.

As regards the JFET resistance, it is to be observed that the portions of the lightly doped layer comprised between two adjacent P body regions form a JFET whose channel, if the distance between the P body regions is small, may be pinched, so that the channel resistance of the JFET increases (JFET effect). In order to keep the JFET resistance small, the distance between adjacent P body regions should be sufficiently high.

Another important feature of the power device is its capability of sustaining high voltages. To this purspose, the distance between adjacent P body regions should be kept as small as possible, to avoid too large a curvature of the equipotential lines associated to the curved edges of the P body regions: in this way, breakdown problems are transferred to the edge of the device where suitable edge termination structure can be provided.

It appears that a trade-off is to be find between opposite requirements: for increasing the voltage capability, the distance between adjacent P body regions should be kept small, while in order to reduce the JFET resistance said distance should be increased, and simultaneously, in order to reduce the Ron, the perimeter of the windows in the polysilicon layer should be increased.

Known solutions can be grouped in two categories: structures having a "cell" layout and structures having a "stripe" layout.

In cell layout structures, the polysilicon layer forms a bidimensional mesh wherein polygonal (e.g., square, circular or hexagonal) windows are opened. With this arrangement, a very large channel perimeter (and consequently a very large channel width) can be achieved; the JFET area is also quite good. The main drawback of these structures is that the distance between the windows in the polysilicon layer is not regular (for example, in the simplest case of square cells, the distance along a diagonal direction is larger that the distance along the direction of the sides of the cells). Another drawback is that a poor optimisation of the gate capacitance can be achived.

In stripe layout structures, elongated rectilinear stripes of polysilicon are defined instead of windows in a polysilicon layer; in this case, a unique P type area ("single body") is defined in the lightly doped layer, said P type area containing "holes" defined by the polysilicon stripes. Rectilinear P body stripes are defined between the polysilicon stripes. The distance between adjacent P body stripes is perfectly controlled, so that a very good optimisation of breakdown voltage can be achieved; also, a good optimisation in terms of gate capacitance can be achieved. However, the optimisation in terms of channel width and JFET area is poor; this is of minor importace in high voltage devices, wherein the main contributor to Ron is the lightly doped layer, but in low voltage devices the increase in Ron is about 20% with respect to cell layout structures.

In view of the state of the art described, it is an object of the present invention to provide a new MOS technology power device structure capable of joining the advantages of both the previously described structures.

According to the present invention, such object is attained by means of a MOS technology power device structure comprising a semiconductor substrate, a lightly doped semiconductor layer of a first conductivity type superimposed over said substrate, a doped region of a second conductivity type formed in the lightly doped layer, said doped region comprising substantially parallel elongated body stripes and a substantially annular frame surrounding said stripes and merged with the body stripes at ends thereof, source regions of the first conductivity type formed inside said body stripes, substantially parallel elongated insulated gate stripes extending over the lightly doped layer between said body stripes, characterized in that said insulated gate stripes have a sinuous layout whereby said body stripes comprise enlarged portions longitudinally intercalated with narrow portions, the enlarged portions of a body stripe being further intercalated in a direction transversal to the body stripes with the narrow portions of adjacent body stripes.

The MOS technology power device structure according to present invention joins the advantages of both the cell layout structure and the stripe layout structure. Like the latter, the structure of the present invention has a single body area; however, the insulated gate stripes are not linear, but sinuous, and this increases the channel perimeter per unit area, with a reduction of Ron. Also, as in the conventional stripe layout structures, the distance between adjacent body stripes is constant.

The features of the present invention will be made more evident by the following detailed description of some particular embodiments, illustrated as non-limiting examples in the annexed drawings, wherein:
Figure 1 is a top-plan view showing a layout of a MOS technology power device according to a first embodiment of the present invention;
Figure 2 is an enlarged top-plan view of a portion of the MOS technology power device of Fig. 1;
Figure 3 is a cross-sectional view along line III-III of Fig. 2;
Figure 4 is a cross-sectional view along line IV-IV of Fig. 2;
Figure 5 is a top-plan view showing a layout of a MOS technology power device according to a second embodiment of the invention; and
Figure 6 is an enlarged top-plan view of a portion of the MOS technology power device of Fig. 5.

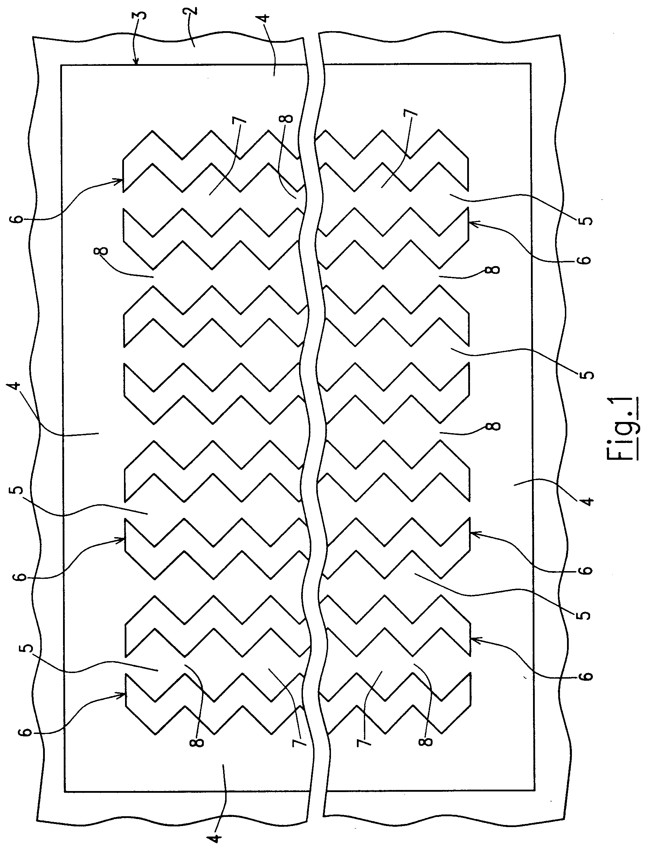

With reference to the drawings, and particularly to Figs. 1 to 4, a MOS technology power device according to a first embodiment of the present invention comprises a semiconductor substrate 1, generally heavily doped, and a lightly doped semiconductor layer 2, typically formed by means of epitaxial growth over substrate 1. The lightly doped layer 2 is of the N conductivity type in the case of an N-channel power device, and of the P conductivity type in the case of a P-channel device; in this example, it will be assumed that layer 2 is of the N conductivity type. Substrate 1 can be of the same conductivity type as layer 2, as in the case of power VDMOSFETs, or of the opposite conductivity type, as in the case of IGBTs; in this example, it will be assumed that substrate 1 is of the N type. However, it is evident that the present invention finds application in both N-channel and P-channel devices, and in both power VDMOSFETs and IGBTs.

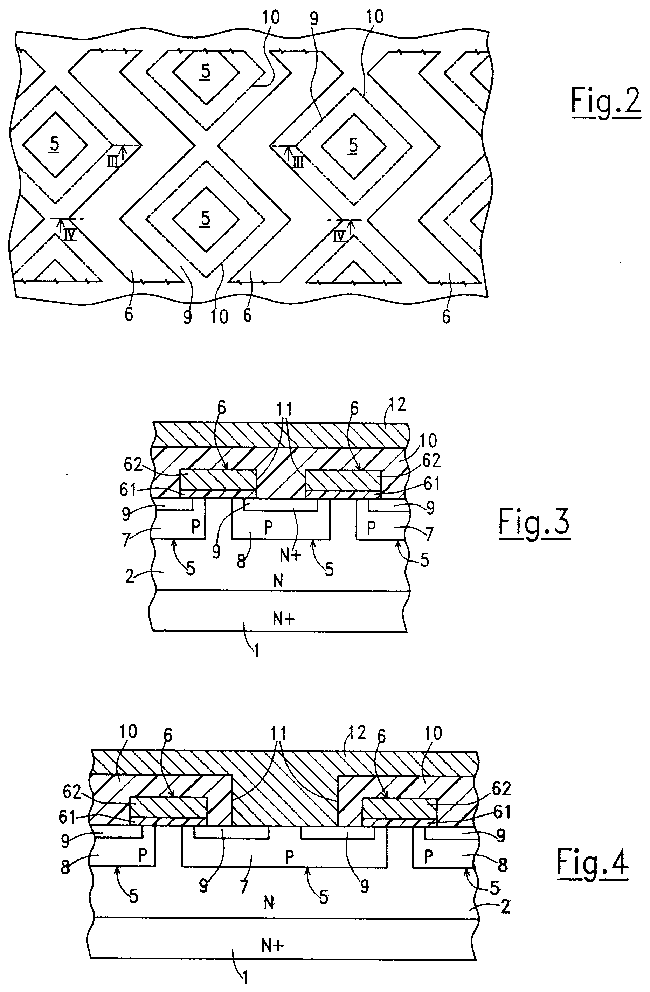

Inside layer 2, a P type doped region 3 is formed; P type region 3 comprises a peripheral P type frame region 4 of substantially annular shape, and a plurality of elongated P type body stripes 5 substantially parallel to one another (Figs. 1 and 2); body stripes 5 are merged at their ends with the peripheral region 4: thus, body stripes 5 and the frame region 4 forms a signle body region. As Visible from Fig. 1, body stripes 5 are separated by elongated insulated gate stripes 6, comprising a gate oxide layer 61 and a polysilicon gate layer 62. The insulated gate stripes 6 have a constant width, but have a sinuous shape; as a consequence, each body stripe 5 comprises enlarged portions 7 intercalated in a longitudinal direction with narrow portions 8; along a direction transversal to the body stripes 5, the enlarged portions 7 of the body stripes are intercalated with the narrow portions of adjacent body stripes.

The shape of the body stripes is a consequence of the particular sinuous shape of the insulated gate stripes, because during the manufacturing of the power device the insulated gate stripes are defined first, and the body stripes are then formed in a self-aligned manner with the insulated gate stripes.

Referring to Figs. 2, 3 and 4, heavily doped source regions 9 of the N type are formed inside the body stripes 5, in such a way as to leave a substantially polygonal portion of body stripe at the center of each enlarged portion 7 of the body stripes 5.

A dielectric layer 10 shown in dash-and-dot line in Fig. 2 covers all the surface of the chip, and substantially polygonal contact windows 11 are opened thereinto substantially over each enlarged portion 7 of the body stripes 5, so that the source region 9 and the central polygonal portions of the body stripes 5 can be contacted and short-circuited together by a source metallization layer 12.

It is to be noted that the polygonal shape of the contact windows 11 and the central portions of the body stripes are not essential to the present invention, other shapes being obviously suitable.

The width of the insulated gate stripes 6, the width of the P body stripes 5, the number and size of contact windows, the spacing between contact windows in a same P body stripes are design parameters which can be optimised depending on the desired voltage capability, the manufacturing apparatus and so on. By way of practical example only, the following sizes can be provided:
width of the insulated gate stripes 6: approximately 4.6 µm;
distance between adjacent body stripes 5: approximately 6.6 µm;
width of the enlarged portions 7 of the body stripes 5: approximately 8.5 µm;
maximum width of the narrow portions 8 of the body stripes 5: approximately 3 µm;
maximum width of the contact windows 11: approximately 4.4 µm;
side of the contact windows: approximately 3.1 µm;
distance between polysilicon stripe edge and edge of contact windows 11: approximately 1.5 µm.

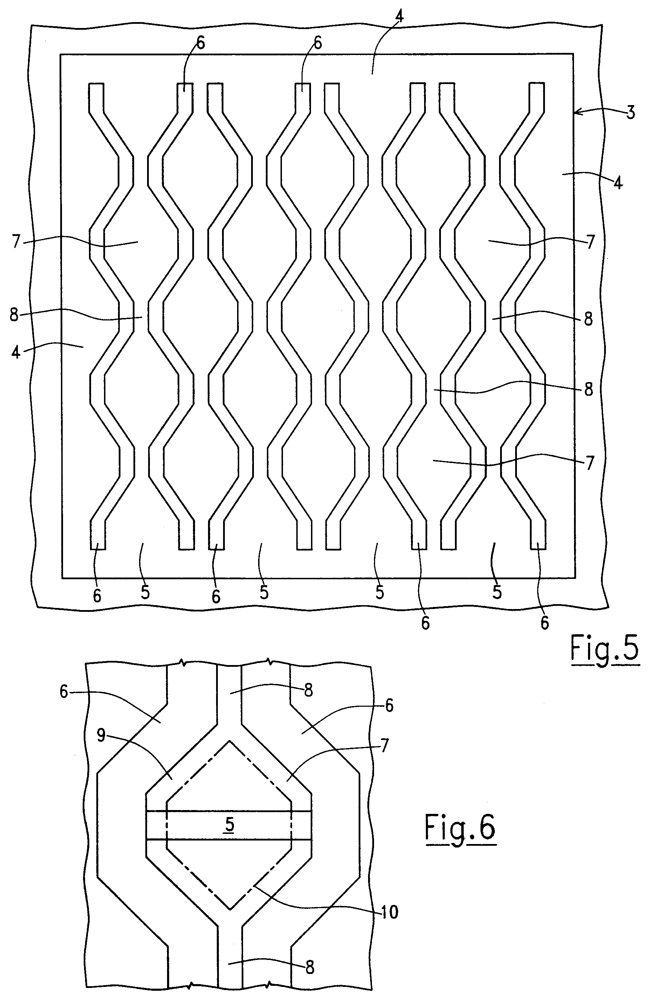

Figures 5 and 6 show in top-plan view a second embodiment of the present invention. In this embodiment, the insulated gate stripes 6 have a slightly different shape with respect to the first embodiment; consequently, also the body stripes 5 have a slightly different shape with respect to the first embodiment. However, also in this embodiment each body stripe 5 comprises enlarged portions 7 longitudinally intercalated with narrow portions 8. Another difference with respect to the first embodiment is the shape of the source regions 9 inside the body stripes 5: as visible from Figure 6, in this embodiment the source region 9 is interrupted in correspondance of the center of each enlarged portion 7 of the body stripe 5, so as to leave a transversal portion of the body stripe 5 uncovered to allow contact by the superimposed source metallization layer.

The structure of the present invention can be used for both low and high voltage devices. The structure of the present invention can also be used in smart-power technologies, wherein power devices are integrated in a same chip with control logic circuits.

## Claims

1. MOS technology power device structure comprising a semiconductor substrate (1), a lightly doped semiconductor layer (2) of a first conductivity type superimposed over said substrate (1), a doped region (3) of a second conductivity type formed in the lightly doped layer, said doped region (3) comprising substantially parallel elongated body stripes (5) of the second conductivity type and a substantially annular frame (4) of the second conductivity type surrounding said body stripes (5) and merged with the body stripes (5) at ends thereof, source regions (9) of the first conductivity type formed inside said body stripes (5), substantially parallel elongated insulated gate stripes (6) extending over the lightly doped layer (2) between said body stripes (5), characterized in that said insulated gate stripes (6) have a sinuous layout whereby said body stripes (5) comprise enlarged portions (7) longitudinally intercalated with narrow portions (8), the enlarged portions (7) of a body stripe being further intercalated in a direction transversal to the body stripes (5) with the narrow portions (8) of adjacent body stripes (5).

2. MOS technology power device according to claim 1, characterized in that said insulated gate stripes (6) have a constant width.

3. MOS technology power device according to claim 1, characterized in that said body stripes (5) extends in said transversal direction under said insulated gate stripes (6).

4. MOS technology power device according to claim 3, characterized in that inside each body stripe (5) a continuous source region (9) of the first conductivity type is provided substantially aligned with edges of adjacent insulated gate stripes (6), said continuous source region (9) comprising holes substantially at the center of said enlarged portions (7) of the body stripe (5).

5. MOS technology power device according to claim 3, characterized in that inside each body stripe (5) a plurality of source regions (9) is provided, each source region being substantially aligned with edges of adjacent insulated gate stripes (6) and being separated in a longitudinal direction by adjacent source regions by transversal uncovered portions of the body stripe substantially at the center of said enlarged portions (7) of the body stripe (5).

6. MOS technology power device according to claim 4 or 5, characterized by comprising an insulating material layer (10) superimposed over the insulated gate stripes (6) and the body stripes (5), contact windows (11) provided in the insulating material layer (10) over said enlarged portions (7) of the body stripes (5), and a metallization layer (12) superimposed over said insulating material layer (10) and contacting the body stripes (5) and the source regions (9) through said contact windows (11).

7. MOS technology power device according to claim 6, characterized in that said insulated gate stripes (6) comprise stripes of a gate oxide layer (61) and stripes of a conductive gate layer (62) superimposed over said stripes of gate oxide layer (61).

8. MOS technology power device according to anyone of the preceding claims, characterized in that said semiconductor substrate (1) is of the first conductivity type.

9. MOS technology power device according to anyone of claims 1 to 7, characterized in that said semiconductor substrate (1) is of the second conductivity type.

10. MOS technology power device according to anyone of the preceding claims, characterized in that said first conductivity type is the N type and said second conductivity type is the P type.

11. MOS technology power device according to anyone of claims 1 to 9, characterized in that said first conductivity type is the P type and said second conductivity type is the N type.
